# EUROPEAN PATENT SPECIFICATION

(11) **EP 4 195 512 B1**
(45) Date of publication and mention of the grant of the patent: **28.10.2026**
(21) Application number: 22217217.3
(22) Date of filing: 23.06.2015
(51) Int. Cl.: H03M 3/00, H03M 7/30, H03M 5/04

(54) **SYSTEMS AND METHODS FOR COMPRESSING A DIGITAL SIGNAL**
SYSTEME UND VERFAHREN ZUR KOMPRIMIERUNG EINES DIGITALEN SIGNALS
SYSTÈMES ET PROCÉDÉS DE COMPRESSION D'UN SIGNAL NUMÉRIQUE

(30) Priority: 25.06.2014 US 201462016881 P; 22.06.2015 US 201514745795
(43) Date of publication of application: 14.06.2023
(62) Document number(s) of the earlier application(s) in accordance with Art. 76 EPC: 15735803.7 / 3 161 964
(73) Proprietor: Cirrus Logic, Inc., Austin, TX 78701 (US)
(72) Inventor: CHESNEY, Brian Parker, Bee Cave, 78738 (US)
(74) Representative: Knöner, Gregor

(56) References cited:
- US-A1- 2008 018 502

## Description

### FIELD OF DISCLOSURE

The present disclosure relates in general to audio systems, and more particularly, to compressing a digital signal in an audio system.

### BACKGROUND

Microphones are ubiquitous on many devices used by individuals, including computers, tablets, smart phones, and many other consumer devices. Generally speaking, a microphone is an electroacoustic transducer that produces an electrical signal in response to deflection of a portion (e.g., a membrane or other structure) of a microphone caused by sound incident upon the microphone.

In a digital microphone system, an analog output signal of the microphone transducer may be processed by an analog-to-digital converter to convert the analog output signal to a digital output signal, which may be communicated over a bus to a digital audio processor for further processing. By communicating a digital signal over the bus rather than an analog signal, the audio signal may be less susceptible to noise.

To adequately represent an audio signal with sufficient quality, the digital output signal may have numerous quantization levels. Numerous quantization levels may require a significant number of digital bits in order that each quantization level is represented by a corresponding digital code. It may be undesirable to transmit digital codes with many bits and/or with bits that change frequently over a digital bus, particularly a serial digital bus, as communication throughput may decrease as the number of bits in digital codes increases.

The document US 2009/0295615 A1 describes a sigma-delta converter that comprises a sigma-delta modulator including a quantizer and a stage adaptation element. The quantizer generates a first quantized signal with a first number of stages and the stage adaptation element derives therefrom a second quantized signal having a second, smaller number of stages.

The document US 7,450,047 B1 relates to a sigma-delta modulator with a feedback digital-to-analog converter that has less resolution than the quantizer. An output truncation circuit is provided to convert an N-bit digital signal given out by the analog-to-digital converter to an M-bit digital signal, wherein N>M.

The document "New Continuous-Time Multibit Sigma-Delta Modulators With Low Sensitivity to Clock Jitter", Colodro et al., IEEE transactions on circuits and systems, Vol. 56, No. 1, 1 January 2009, pages 74-83, describes a sigma-delta modulator in which the output of a multibit quantizer is digitally converted to a single-bit pulsewidth-modulated (PWM) signal at higher rate. In the feedback path of the sigma-delta modulator, a finite-impulse-response DAC is used to convert the PWM signal to an analog signal.

The document US 7,649,484 B1 describes the use of compression and decompression to reduce the digital interface rate of an analog-to-digital and digital-to-analog converter.

The document US 2008/0018502 A1 describes the compression of signal samples output from a parallel time-interleaved analog to digital converter (TIDAC) for a baseband signal. Such sampling technique allows sample rates above 100 Msamp/sec, which finds application in test and measurement equipment for testing electronic devices, such as devices related to mobile network or WiFi communication.

### SUMMARY

In accordance with the teachings of the present disclosure, certain disadvantages and problems associated with communication of a digital signal may be reduced or eliminated.

The invention is defined in the independent claims. Particular embodiments are set out in the dependent claims.

In accordance with embodiments of the present disclosure, a system may comprise a digital compression circuit configured to receive an uncompressed digital signal and compress the uncompressed digital signal into a compressed digital signal having fewer quantization levels than that of the uncompressed digital signal. For each given sample of the uncompressed digital signal, the digital compression circuit may generate a corresponding sample of the compressed digital signal based on at least a first quantization level transition between the given sample and a first previous sample sampled consecutively previous to the given sample and a second quantization level transition between the first previous sample and a second previous sample sampled consecutively previous to the first previous sample.

In accordance with these and other embodiments of the present disclosure, an integrated circuit may comprise a digital compression circuit configured to receive an uncompressed digital signal and compress the uncompressed digital signal into a compressed digital signal having fewer quantization levels than that of the uncompressed digital signal. For each given sample of the uncompressed digital signal, the digital compression circuit may generate a corresponding sample of the compressed digital signal based on at least a first quantization level transition between the given sample and a first previous sample sampled consecutively previous to the given sample and a second quantization level transition between the first previous sample and a second previous sample sampled consecutively previous to the first previous sample. The integrated circuit may further comprise a digital processing circuit for processing at least one of the uncompressed digital signal and the compressed digital signal.

In accordance with these and other embodiments of the present disclosure, a method may comprise compressing an uncompressed digital signal into a compressed digital signal having fewer quantization levels than that of the uncompressed digital signal and for each given sample of the uncompressed digital signal, generating a corresponding sample of the compressed digital signal based on at least a first quantization level transition between the given sample and a first previous sample sampled consecutively previous to the given sample and a second quantization level transition between the first previous sample and a second previous sample sampled consecutively previous to the first previous sample.

In accordance with these and other embodiments of the present disclosure, a system may include a delta-sigma analog-to-digital converter and a digital compression circuit. The delta-sigma analog-to-digital converter may include a loop filter having a loop filter input configured to receive an input signal and generate an intermediate signal responsive to the input signal, a multi-bit quantizer configured to quantize the intermediate signal into an uncompressed digital output signal, and a feedback digital-to-analog converter having a feedback output configured to generate a feedback output signal responsive to the uncompressed digital output signal in order to combine the input signal and the feedback output signal at the loop filter input. The digital compression circuit may be configured to receive the uncompressed digital output signal and compress the uncompressed digital output signal into a compressed digital output signal having fewer quantization levels than that of the uncompressed digital output signal.

In accordance with these and other embodiments of the present disclosure, a method may include receiving an analog input signal at a loop filter input and filtering the analog input signal to generate an intermediate signal responsive to the input signal. The method may also include quantizing the intermediate signal into an uncompressed digital output signal. The method may further include converting the uncompressed digital output signal into an analog feedback output in order to combine the input signal and the feedback output signal at the loop filter input. The method may additionally include compressing the uncompressed digital output signal into a compressed digital output signal having fewer quantization levels than that of the uncompressed digital output signal.

In accordance with these and other embodiments of the present disclosure, an integrated circuit may include a transducer, a delta-sigma analog-to-digital converter, a digital compression circuit, and a digital processing circuit. The transducer may be configured to generate the input signal indicative of a physical quantity measured by the transducer. The delta-sigma analog-to-digital converter may include a loop filter having a loop filter input configured to receive an input signal and generate an intermediate signal responsive to the input signal, a multi-bit quantizer configured to quantize the intermediate signal into an uncompressed digital output signal, and a feedback digital-to-analog converter having a feedback output configured to generate a feedback output signal responsive to the uncompressed digital output signal in order to combine the input signal and the feedback output signal at the loop filter input. The digital compression circuit may be configured to receive the uncompressed digital output signal and compress the uncompressed digital output signal into a compressed digital output signal having fewer quantization levels than that of the uncompressed digital output signal. The digital processing circuit may be configured to process at least one of the uncompressed digital output signal and the compressed digital output signal to determine a characteristic of the input signal.

Technical advantages of the present disclosure may be readily apparent to one having ordinary skill in the art from the figures, description and claims included herein. The objects and advantages of the embodiments will be realized and achieved at least by the elements, features, and combinations particularly pointed out in the claims.

It is to be understood that both the foregoing general description and the following detailed description are explanatory examples and are not restrictive of the claims set forth in this disclosure.

### BRIEF DESCRIPTION OF THE DRAWINGS

A more complete understanding of the present embodiments and advantages thereof may be acquired by referring to the following description taken in conjunction with the accompanying drawings, in which like reference numbers indicate like features, and wherein:
FIGURE 1 illustrates a block diagram of selected components of an example system, in accordance with embodiments of the present disclosure;
FIGURE 2 illustrates an example transition graph indicative of transition statistics of a multi-bit quantizer, in accordance with embodiments of the present disclosure;
FIGURES 3A and 3B each illustrates a block diagram of selected components that may be used in lieu of a portion of the system displayed in FIGURE 1; and
FIGURE 4 illustrates a block diagram of selected components of another example system, in accordance with embodiments of the present disclosure.

### DETAILED DESCRIPTION

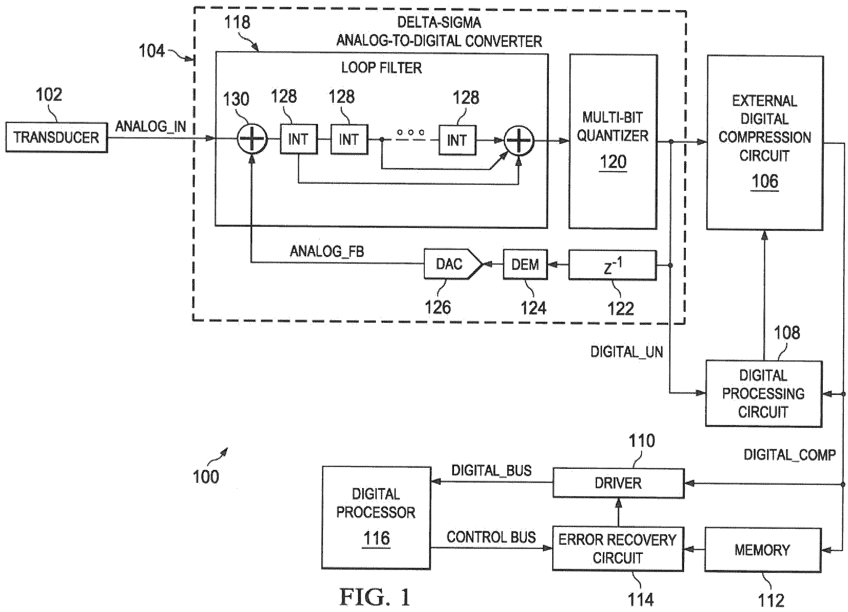

FIGURE 1 illustrates a block diagram of selected components of an example system 100, in accordance with embodiments of the present disclosure. As shown in FIGURE 1, system 100 may include a transducer 102, a delta-sigma analog-to-digital converter (ADC) 104, an external digital compression circuit 106, a digital processing circuit 108, a driver 110, a memory 112, an error recovery circuit 114, and a digital audio processor 116.

Transducer 102 may comprise any system, device, or apparatus configured to sense a physical quantity and convert such physical quantity into an electrical analog signal ANALOG_IN indicative of such physical quantity. For example, in some embodiments, transducer 102 may comprise a microphone transducer configured to generate input signal ANALOG_IN indicative of audio sounds incident upon the microphone transducer, wherein such sound is converted to an electrical signal using a diaphragm or membrane having an electrical capacitance that varies as based on sonic vibrations received at the diaphragm or membrane. In such embodiments, transducer 102 may include an electrostatic microphone, a condenser microphone, an electret microphone, a microelectromechanical systems (MEMs) microphone, or any other suitable capacitive microphone. In other embodiments, transducer 102 may comprise seismic data acquisition equipment, such as a geophone for generating input signal ANALOG_IN indicative of acceleration sensed by the geophone.

Delta-sigma ADC 104 may comprise any suitable system device or apparatus configured to convert analog input signal ANALOG_IN received at its input, to an uncompressed digital output signal DIGITAL_UN representative of analog input signal ANALOG_IN. As shown in FIGURE 1, delta-sigma ADC 104 may include a loop filter 118, a multi-bit quantizer 120, dynamic element matching circuitry (DEM) 124, a digital-to-analog converter (DAC) 126, and a delay block 122.

Loop filter 118 may comprise an input summer 130 for generating a difference between analog input signal ANALOG_IN and an analog feedback signal ANALOG_FB, and one or more integrator stages 128, such that loop filter 118 operates as an analog filter of an error signal equal to the difference between analog input signal ANALOG_IN and analog feedback signal ANALOG_FB, and generates a filtered output analog signal to multi-bit quantizer 120 based on analog input signal ANALOG_IN and analog feedback signal ANALOG_FB (e.g., the difference or error between analog input signal ANALOG_IN and analog feedback signal ANALOG_FB).

Multi-bit quantizer 120 may comprise any system, device, or apparatus configured to receive the filtered output analog signal from loop filter 118, and convert the filtered output analog signal into an uncompressed digital output signal DIGITAL_UN having a plurality of quantization levels (e.g., more than four), as is known in the art. In some embodiments, uncompressed digital output signal DIGITAL_UN may be a signal of length M, where M is a positive integer. In particular embodiments, M may be greater or equal to 3.

Digital feedback signal DIGITAL_INT may be delayed by delay block 122 and fed back through DEM circuitry 124 and DAC 126 to generate analog feedback signal ANALOG_FB.

External digital compression circuit 106 may comprise any system, device, or apparatus configured to receive uncompressed digital output signal DIGITAL_UN and compress uncompressed digital output signal DIGITAL_UN into a compressed digital output signal DIGITAL_COMP having fewer quantization levels than that of uncompressed digital output signal DIGITAL_UN, as described in greater detail elsewhere in this disclosure. For example, in some embodiments, uncompressed digital output signal DIGITAL_UN may comprise M bits and external digital compression circuit 106 may compress uncompressed digital output signal DIGITAL_UN into compressed digital output signal DIGITAL_COMP comprising N bits, where M and N are each positive integers and M is greater than N.

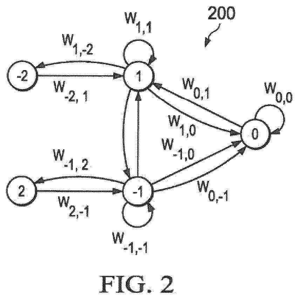

In some embodiments, a function of external digital compression circuit 106 for compressing uncompressed digital output signal DIGITAL_UN into compressed digital output signal DIGITAL_COMP is selected based on transition statistics of multi-bit quantizer 120 and uncompressed digital output signal DIGITAL_UN. For example, turning briefly to FIGURE 2, depicted is an example transition graph 200 for uncompressed digital output signal DIGITAL_UN output by multi-bit quantizer 120 for an analog input signal ANALOG_IN of a particular characteristic (e.g., an audio band signal generated by a digital microphone). Nodes of transition graph 200 represent differences of quantization level in successive samples of uncompressed digital output signal DIGITAL_UN. Directed edges of transition graph 200 may represent a quantization level transition that may occur between a current sample and a most-recent sample based on the previous quantization level transition between the most-recent sample and the sample occurring immediately prior to the most-recent sample, and weights (e.g., w_{0,0}, w_{0,1}, w_{0,-1}, w_{1,0}, w_{1,1}, w_{1,-1}, w_{1,-2}, w_{-1,0}, w_{-1,-1}, w_{-1,1}, w_{-1,2}, w_{2,-1}, w_{-2,1}) on directed edges of transition graph may represent a probability or likelihood that a given transition may occur based on statistics of multi-bit quantizer 120 and/or the analog input signal ANALOG_IN. For example, in the example transition graph 200, when a quantization level transition of 0 occurs in uncompressed digital output signal DIGITAL_UN, the next quantization level transition may be 0, -1, or +1. Additionally, when a quantization level transition of +1 occurs in uncompressed digital output signal DIGITAL_UN, the next quantization level transition may be 0, -1, +1, or -2. Similarly, when a quantization level transition of -1 occurs in uncompressed digital output signal DIGITAL_UN, the next quantization level transition may be 0, -1, +1, or +2. Furthermore, when a quantization level transition of +2 occurs in uncompressed digital output signal DIGITAL_UN, the next quantization level transition may be -1 or -2, and when a quantization level transition of +2 occurs in uncompressed digital output signal DIGITAL_UN, the next quantization level transition may be -1, or -2. Thus, no node in transition graph 200 has more than four directed edges originating from it, and thus the various quantization levels (e.g., 16 quantization levels represented by four bits in a pulse-density modulated signal) of uncompressed digital output signal DIGITAL_UN may be encoded into two bits of transition information. The limitation of next quantization level transitions from certain present quantization level transitions may be limited due to the band-limiting nature of loop filter 118 and/or transducer 102. For example, due to the band-limiting nature of loop filter 118 and/or transducer 102, multi-bit quantizer 120 may not be instructed to increase by two quantization levels immediately after an increase by one quantization level. Accordingly, a function of external digital compression circuit 106 for compressing uncompressed digital output signal DIGITAL_UN into compressed digital output signal DIGITAL_COMP may limit possible transitions between quantization levels of uncompressed digital output signal DIGITAL_UN of consecutive samples of uncompressed digital output signal DIGITAL_UN to a subset of quantization levels of the uncompressed digital output signal DIGITAL_UN.

Thus, for an uncompressed digital output signal DIGITAL_UN having transition statistics represented by transition graph 200, external digital compression circuit 106 may have four different quantization levels, each represented by a two-bit code as shown in the following Table 1:

**Table 1**

| Transition | Description | Code |
|---|---|---|
| TOGGLE1 | Toggle between adjacent quantizer levels of DIGITAL_UN | 00 |
| HOLD | Hold the previous value of DIGITAL_UN | 11 |
| INCDEC | Increment or decrement to next higher or lower quantization level of DIGITAL_UN | 01 |
| TOGGLE2 | Toggle between quantizer levels of DIGITAL_UN differing by 2 | 10 |

In addition, for an uncompressed digital output signal DIGITAL_UN having transition statistics represented by transition graph 200, external digital compression circuit 106 may maintain a state variable DIRECTION that indicates whether the last transition was an increase or decrease of uncompressed digital output signal DIGITAL_UN. Thus, if a current sample of uncompressed digital output signal DIGITAL_UN is larger than a previous sample and the variable DIRECTION has a value "UP" indicating that the last transition was an increase of uncompressed digital output signal DIGITAL_UN, the output code corresponding to INCDEC may be output as compressed digital output signal DIGITAL_COMP as uncompressed digital output signal DIGITAL_UN is not toggling between two quantizer levels and is not holding at its current value. Similarly, if a current sample of uncompressed digital output signal DIGITAL_UN is smaller than a previous sample and the variable DIRECTION has a value "DOWN" indicating that the last transition was a decrease of uncompressed digital output signal DIGITAL_UN, the output code corresponding to INCDEC may be output as compressed digital output signal DIGITAL_COMP, as uncompressed digital output signal DIGITAL_UN is not toggling between two quantizer levels and is not holding at its current value.

For an uncompressed digital output signal DIGITAL_UN having transition statistics represented by transition graph 200 and external digital compression circuit 106 applying a function as described above with respect to Table 1, the following Table 2 sets forth an example algorithm/function applied by external digital compression circuit 106, where v[n] represents the value of the nth sample of uncompressed digital output signal DIGITAL_UN, y[n] represents a sample of compressed digital output signal DIGITAL_COMP output in response to receipt of v[n], and DIRECTION[n] represents the value of DIRECTION calculated in response to receipt of v[n]:

**Table 2**

| v[n] - v[n-1] | DIRECTION[n-1] | y[n] | DIRECTION[n] |
|---|---|---|---|
| 0 | DOWN | HOLD | DOWN |
| 0 | UP | HOLD | UP |
| -1 | DOWN | TOGGLE1 | DOWN |
| -1 | UP | INCDEC | DOWN |
| +1 | DOWN | INCDEC | UP |
| +1 | UP | TOGGLE1 | UP |
| -2 | DOWN | TOGGLE2 | DOWN |
| +2 | UP | TOGGLE2 | UP |

Different but similar algorithms/functions may be applied to multi-bit quantizers 120 having more quantization levels and/or to an uncompressed digital output signal DIGITAL_UN having different transition statistics than that shown above. Furthermore, such different but similar algorithms/functions may provide for additional quantization levels for compressed digital output signal DIGITAL_COMP beyond those described above (e.g., output codes corresponding to transitions of INCDEC2, INCDEC3, TOGGLE3, TOGGLE4, etc.). Thus, a function of external digital compression circuit 106 for compressing uncompressed digital output signal DIGITAL_UN into compressed digital output signal DIGITAL_COMP may be selected based on transition statistics of the multi-bit quantizer.

Also, as seen above, for each given sample of uncompressed digital output signal DIGITAL_UN, external digital compression circuit 106 may generate a corresponding sample of compressed digital output signal DIGITAL_COMP based on transition statistics of multi-bit quantizer 120. For example, in the example above, a sample of compressed digital output signal DIGITAL_COMP generated in response to receipt of uncompressed digital output signal DIGITAL_UN may be based on not only the corresponding sample of uncompressed digital output signal DIGITAL_UN, but also on a previous sample of uncompressed digital output signal DIGITAL_UN, as represented by the state variable DIRECTION. However, different but similar algorithms/functions may be applied to multi-bit quantizers 120 having more quantization levels and/or to an uncompressed digital output signal DIGITAL_UN having different transition statistics than that shown above to generate compressed digital output signal DIGITAL_COMP based on more than the two most recent samples of uncompressed digital output signal DIGITAL_UN.

In some embodiments, a function of external digital compression circuit 106 for compressing the uncompressed digital output signal into a compressed digital output signal is selected based on transition statistics of multi-bit quantizer 120 in order to minimize transition frequency of the N bits of external digital compression circuit 106. For example, if the transition statistics indicate that compressed digital output signal DIGITAL_COMP indicates transitions of HOLD and TOGGLE1 a substantial percentage of the time, a function of external digital compression circuit 106 may provide that the output codes for HOLD and TOGGLE1 are such that only one bit of compressed digital output signal DIGITAL_COMP transitions when the transition indicated by digital output signal DIGITAL_COMP changes from HOLD to TOGGLE1 or vice versa. Thus, in this example, if HOLD were represented by a code "00," TOGGLE1 may be represented by output code "01" or "10," such that only one bit of compressed digital output signal DIGITAL_COMP transitions when the transition indicated by digital output signal DIGITAL_COMP changes from HOLD to TOGGLE1 or vice versa. By minimizing the number of transitions of compressed digital output signal DIGITAL_COMP in this manner, power consumption associated with generating and transmitting digital output signal DIGITAL_COMP may be minimized.

Furthermore, in these and other embodiments, a function of external digital compression circuit 106 may limit possible transitions between quantization levels of uncompressed digital output signal DIGITAL_UN of consecutive samples of the uncompressed digital output signal DIGITAL_UN, as described above, such that compression is lossless (e.g., the signal reconstructed by digital processor 116 is equivalent to the uncompressed digital output signal DIGITAL_UN). In other embodiments in which compression is not lossless, limiting possible transitions between quantization levels of uncompressed digital output signal DIGITAL_UN of consecutive samples of the uncompressed digital output signal DIGITAL_UN may also minimize degradation to the signal such that compression artifacts are minimal or are outside a frequency band of interest (e.g., outside the range of human hearing).

In some embodiments, the function applied by external digital compression circuit 106 to compress uncompressed digital output signal DIGITAL_UN into compressed digital output signal DIGITAL_COMP may be static and determined based on characterization and testing of system 100 or portions thereof prior to packaging or shipment to an intended end user, using waveforms for analog input signal ANALOG_IN expected for the type of application in which system 100 is to be used. In other embodiments, functions may be dynamically selected by digital processing circuit 108 based on characteristics of analog input signal ANALOG_IN, as described below.

Turning again to FIGURE 1, digital processing circuit 108 may comprise any system, device, or apparatus configured to process at least one of uncompressed digital output signal DIGITAL_UN and compressed digital output signal DIGITAL_COMP to determine a characteristic of analog input signal ANALOG_IN. For example, in some embodiments in which transducer 102 comprises a microphone, digital processing circuit 108 may process at least one of uncompressed digital output signal DIGITAL_UN and compressed digital output signal DIGITAL_COMP to perform voice detection (e.g., detection of a particular individual's voice and/or detection of particular words of phrases uttered by an individual). In these and other embodiments in which transducer 102 comprises a microphone, digital processing circuit 108 may process at least one of uncompressed digital output signal DIGITAL_UN and compressed digital output signal DIGITAL_COMP to determine mel-frequency cepstral coefficients of the input signal, which may aid in performance of voice detection. In these and other embodiments in which transducer 102 comprises a microphone, digital processing circuit 108 may process at least one of uncompressed digital output signal DIGITAL_UN and compressed digital output signal DIGITAL_COMP to detect the presence of ultrasonic energy in the input signal (e.g., spectral energy above the range of human hearing).

While the foregoing discussion contemplates processing of signals indicative of speech, the systems and methods described herein may be applied to any type of signal, whether speech, music, other audio signals, ultrasonic signals, or infrasonic signals.

In these and other embodiments, digital processing circuit 108 may be configured to control external digital compression circuit 106 to set a number of bits comprising compressed digital output signal DIGITAL_COMP based on the sensed or detected characteristic of analog input signal ANALOG_IN. For instance, digital processing circuit 108 may be configured to set the number of bits to a first number if the input signal has energy above a particular frequency (e.g., ultrasonic) and set the number of bits to a second number if the input signal lacks energy above the particular frequency (e.g., sonic). Thus, for ultrasonic energy, external digital compression circuit 106 may use a lower compression ratio than for a signal with wholly sonic energy.

Driver 110 may receive the digital signal DIGITAL_COMP output by external digital compression system 106 and may comprise any suitable system, device, or apparatus configured to condition such digital signal (e.g., encoding into Audio Engineering Society/European Broadcasting Union (AES/EBU), Sony/Philips Digital Interface Format (S/PDIF)), in the process generating digital output signal DIGITAL_BUS for transmission over a bus to digital processor 116. In FIGURE 1, the bus receiving digital output signal DIGITAL_BUS is shown as single-ended. In some embodiments, driver 110 may generate a differential digital audio output signal.

Memory 112 may comprise any system, device, or apparatus configured to retain program instructions and/or data for a period of time (e.g., computer-readable media). Memory 112 may include RAM, EEPROM, a PCMCIA card, flash memory, magnetic storage, opto-magnetic storage, or any suitable selection and/or array of volatile or nonvolatile memory that retains data after power to system 100 or portions thereof is turned off. In operation in system 100, memory 112 may be configured to store one or more compressed digital samples of the compressed digital output signal in order of transmission as transmitted from driver 110. Accordingly, memory 112 may be coupled to error recovery circuit 114, which may be configured to, in response to an error in transmission of digital output signal DIGITAL_BUS, read the one or more compressed samples from memory 104 and cause driver 110 to re-transmit the one or more compressed digital samples. In some embodiments, error recovery circuit 114 may determine a transmission error has occurred and/or the nature of such transmission error based on one or more control signals communicated from a control bus between digital processor 116 and error recovery circuit 114.

Digital processor 116 may comprise any suitable system, device, or apparatus configured to process digital output signal DIGITAL_BUS for use in a digital system (e.g., an audio system). For example, digital processor 116 may comprise a microprocessor, microcontroller, digital signal processor (DSP), application specific integrated circuit (ASIC), or any other device configured to interpret and/or execute program instructions and/or process data, such as a digital audio output signal. In some embodiments, digital processor 116 may receive the digital signal DIGITAL_BUS and reconstruct a digital signal with the same number of quantization levels as uncompressed digital output signal DIGITAL_UN by applying a function which is a dual or inverse of that of external digital compression circuit 106. Accordingly, in embodiments in which digital processing circuit 108 may dynamically change a function applied by external digital compression circuit 106, one or more components of system 100 may be configured to communicate one or more control signals to digital processor 116 indicative of such change in compression function such that digital processor 116 may cause a corresponding change to its decompression function.

A change in compression function may be communicated to the digital processor 116 via an interrupt issued to the digital processor 116 or through some other side channel communication. In some systems, activating an interrupt or communicating through a side channel may be virtually free as the system would be configured to service interrupts, regardless of whether or not the data is being compressed. An example of such a system is a digital microphone communicating over a Soundwire^{™} serial link to a digital processor 116. In such a system the microphone utilizes features of the Soundwire^{™} bus protocol to interrupt digital processor 116 to change its compression without the need for an additional pin on the microphone or an additional communication channel into digital processor 116.

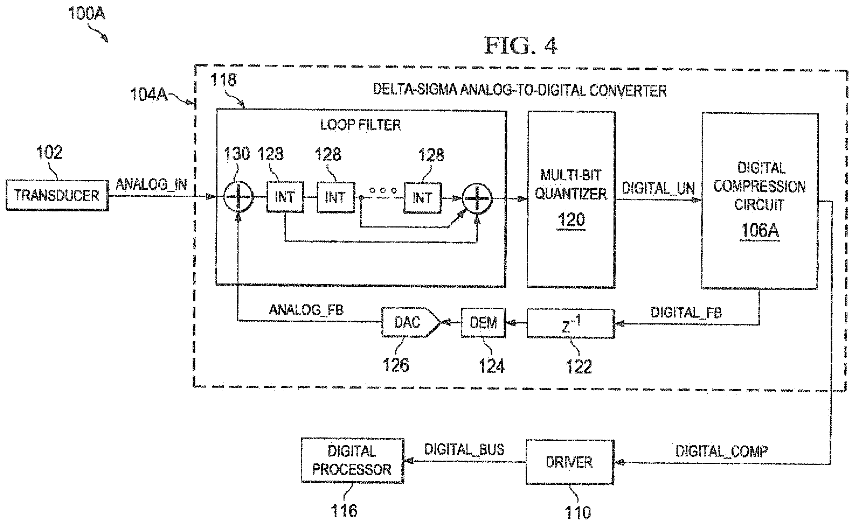

Other systems may lack the ability to send side channel information for virtually free as in the Soundwire^{™} example described above. In such systems, the need to communicate a change in compression ratio may actually place an undue burden on the system. That is, the cost of communicating the change in compression ratio may mitigate the advantages of compression in the first place. In some systems, it may be acceptable to have inexact recovery at the digital processor 116. For systems that need a constant compression ratio and can tolerate some amount of signal degradation, the embodiment in FIGURE 4, described in greater detail below, may be preferred.

In some embodiments of system 100, transducer 102, delta-sigma ADC 104, and external digital compression circuit 106 may be formed on a single substrate (e.g., the same semiconductor substrate). In other embodiments of system 100, transducer 102, delta-sigma ADC 104, and external digital compression circuit 106 may be formed on different substrates packaged within the same integrated circuit package.

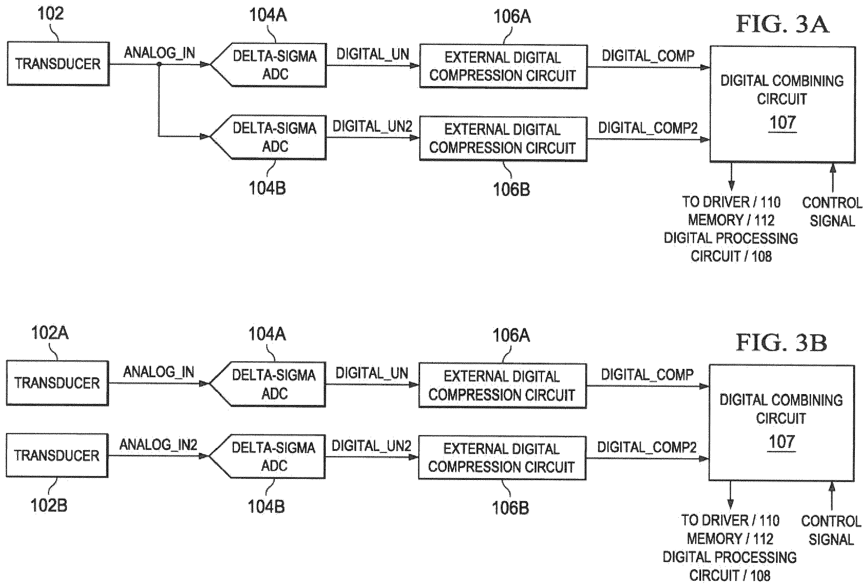

FIGURE 3A illustrates a block diagram of selected components that may be used in lieu of a portion of system 100, in accordance with embodiments of the present disclosure. As shown in FIGURE 3A, delta-sigma ADC 104 may be replaced with two delta-sigma ADCs 104A and 104B. In addition, external digital compression circuit 106 may be replaced with two external digital compression circuits 106A and 106B.

Each delta-sigma ADC 104A and 104B may include components (e.g., loop filter 118, multi-bit quantizer 120, delay block 122, DEM circuitry 124, and feedback DAC 126) as shown in FIGURE 1 for delta-sigma ADC 104. As shown in FIGURE 3A, delta-sigma ADCs 104A and 104B may each convert analog input signal ANALOG_IN into respective uncompressed digital output signals DIGITAL_UN and DIGITAL_UN2. Each of uncompressed digital output signals DIGITAL_UN and DIGITAL_UN2 may be input to a respective external digital compression circuit 106A and 106B for compressing each of uncompressed digital output signals DIGITAL_UN and DIGITAL_UN2 into respective compressed digital output signals DIGITAL_COMP and DIGITAL_COMP2, in a manner similar or identical to that described above with respect to external digital compression circuit 106. The compressed digital output signals DIGITAL_COMP and DIGITAL_COMP2 may be combined by a digital combining circuit 107, with the resulting signal communicated to driver 110, memory 112, digital processing circuit 108, and/or other components of system 100 in a manner identical or similar to that of compressed digital output signal DIGITAL_COMP depicted in FIGURE 1. As shown in FIGURE 3A, digital combining circuit 107 may receive a control signal (e.g., from digital processing circuit 108 or other source) which may select between digital output signals DIGITAL_COMP and DIGITAL_COMP2 or indicate respective weights of digital output signals DIGITAL_COMP and DIGITAL_COMP2 to be applied to the output signal generated by digital combining circuit 107. In some embodiments, the control signal may be indicative of a magnitude of analog input signal ANALOG_IN or a signal derivative therefrom.

FIGURE 3B illustrates a block diagram of selected components that may be used in lieu of a portion of system 100, in accordance with embodiments of the present disclosure. FIGURE 3B is similar to that of FIGURE 3A, except that transducer 102 is replaced with two transducers 102A and 102B, which each produce respective analog input signals ANALOG_IN and ANALOG_IN2. As shown in FIGURE 3B, delta-sigma ADCs 104A and 104B may each convert their respective analog input signals ANALOG_IN and ANALOG_IN2 into respective uncompressed digital output signals DIGITAL_UN and DIGITAL_UN2. Each of uncompressed digital output signals DIGITAL_UN and DIGITAL_UN2 may be input to a respective external digital compression circuit 106A and 106B for compressing each of uncompressed digital output signals DIGITAL_UN and DIGITAL_UN2 into respective compressed digital output signals DIGITAL_COMP and DIGITAL_COMP2, in a manner similar or identical to that described above with respect to external digital compression circuit 106. The compressed digital output signals DIGITAL_COMP and DIGITAL_COMP2 may be combined by a digital combining circuit 107, with the resulting signal communicated to driver 110, memory 112, digital processing circuit 108, and/or other components of system 100 in a manner identical or similar to that of compressed digital output signal DIGITAL_COMP depicted in FIGURE 1.

In each of FIGURES 3A and 3B, external digital compression circuit 106A may be configured to receive uncompressed digital output signal DIGITAL_UN having M bits and compress uncompressed digital output signal DIGITAL_UN into compressed digital output signal DIGITAL_COMP having N bits, wherein M and N are each positive integers and M > N. Similarly, external digital compression circuit 106B may be configured to receive uncompressed digital output signal DIGITAL_UN having Y bits and compress uncompressed digital output signal DIGITAL_UN into compressed digital output signal DIGITAL_COMP having Z bits, wherein Y and Z are each positive integers and Y > Z. In some embodiments, M=Y. In these and other embodiments, N=Z.

The approaches of FIGURES 3A and 3B may be used to perform dual-path or multi-path dynamic range enhancement in a system. For example, the dynamic range of transducer 102 or system 100 in general may be extended by having the multiple processing paths each having a respective gain, and selecting one or the paths or combining the paths in a manner to provide a wider dynamic range than one path along might provide.

FIGURE 4 illustrates a block diagram of selected components of another example system 100A, in accordance with embodiments of the present disclosure, which may be used as an alternative to system 100 of FIGURE 1. FIGURE 4 may be similar to FIGURE 1 in that it may include a transducer 102, a delta-sigma ADC 104A, and a digital compression circuit 106A similar in structure and/or function to transducer 102, delta-sigma ADC 104, and digital compression circuit 106 of FIGURE 1, except as described below.

As shown in FIGURE 4, delta-sigma ADC 104A may differ from delta-sigma ADC 104 in that digital compression circuit 106A is internal to delta-sigma ADC 104A and may, in addition to compressing uncompressed digital output signal DIGITAL_UN into compressed digital output signal DIGITAL_COMP as does digital compression circuit 106 of FIGURE 1, digital compression circuit 106A may also generate a digital feedback signal DIGITAL_FB indicative of the generated compressed digital output signal DIGITAL_COMP. For example, the compression function of digital compression circuit 106A may be limited in the magnitude of transitions of uncompressed digital output signal DIGITAL_UN that it may represent, and if a magnitude of transition of uncompressed digital output signal DIGITAL_UN is other than that which can accurately be represented by compressed digital output signal DIGITAL_COMP, compressed digital output signal DIGITAL_COMP may simply estimate the transition in accordance with its limited set of output codes. For example, if successive samples of uncompressed digital output signal DIGITAL_UN are 5 and 9, but digital compression circuit 106A is only capable of outputting digital codes for compressed digital output signal DIGITAL_COMP that represent a maximum of a change in magnitude of 2 for uncompressed digital output signal DIGITAL_UN, digital compression circuit 106A may simply output the digital code corresponding to an increase of 2 of the magnitude of uncompressed digital output signal DIGITAL_UN. In addition, digital compression circuit 106A may output digital feedback signal DIGITAL_FB indicative of the magnitude of uncompressed digital output signal DIGITAL_UN represented by compressed digital output signal DIGITAL_COMP. Thus, in the present example in which successive samples of uncompressed digital output signal DIGITAL_UN are 5 and 9 and digital compression circuit 106A outputs the digital code corresponding to an increase of 2 of the magnitude of uncompressed digital output signal DIGITAL_UN, digital compression circuit 106A may output digital feedback signal DIGITAL_FB with a value of 7 (i.e., the previous sample for uncompressed digital output signal DIGITAL_UN of 5 plus the change in magnitude of 2 indicated by compressed digital output signal DIGITAL_COMP).

In some instances, the embodiments represented by FIGURE 4 may be preferred over the embodiments represented by FIGURE 1, as system 100A may not require memory 112 nor error recovery circuit 114 as does system 100 of FIGURE 1. In addition, system 100A may be capable of operating with a fixed compression ratio under all input conditions with an acceptable amount of signal degradation.

All examples and conditional language recited herein are intended for pedagogical objects to aid the reader in understanding the disclosure and the concepts contributed by the inventor to furthering the art, and are construed as being without limitation to such specifically recited examples and conditions. Although embodiments of the present disclosure have been described in detail, it should be understood that various changes, substitutions, and alterations could be made hereto without departing from the scope of the disclosure.

## Claims

1. A system comprising:
a digital compression circuit (106, 106A) configured to receive an uncompressed digital signal and compress the uncompressed digital signal into a compressed digital signal having fewer quantization levels than that of the uncompressed digital signal, wherein for each given sample of the uncompressed digital signal, the digital compression circuit generates a corresponding sample of the compressed digital signal based on at least a first quantization level transition between the given sample and a first previous sample sampled consecutively previous to the given sample;
**characterised in that** the compressed digital signal is further based on
a second quantization level transition between the first previous sample and a second previous sample sampled consecutively previous to the first previous sample.

2. The system of claim 1, wherein:
the uncompressed digital signal comprises M bits;
the compressed digital signal comprises N bits; and
M and N are each positive integers and M>N.

3. The system of claim 1 or 2, wherein for each given sample of the uncompressed digital signal, the digital compression circuit (106, 106A) generates a corresponding sample of the compressed digital signal based on transition statistics of a multi-bit quantizer (120).

4. The system of any of the preceding claims, wherein a function of the digital compression circuit (106, 106A) for compressing the uncompressed digital signal into the compressed digital signal is selected based on transition statistics of a multi-bit quantizer (120) in order to minimize transition frequency of bits making up the compressed digital signal, and/or
wherein a function of the digital compression circuit (106, 106A) for compressing the uncompressed digital signal into the compressed digital signal limits possible transitions between quantization levels of the uncompressed digital signal of consecutive samples of the uncompressed digital signal to a subset of the quantization levels of the uncompressed digital signal,
wherein preferably, the function limits possible transitions between quantization levels of the uncompressed digital signal of consecutive samples of the uncompressed digital signal in order to minimize degradation to the compressed digital signal.

5. The system of any of the preceding claims, further comprising a processing circuit (116) for decompressing the compressed digital signal.

6. The system of any of the preceding claims, further comprising:
a driver (110) configured to transmit the compressed digital signal;
a memory (112) configured to store one or more transmitted compressed digital samples of the compressed digital signal in order of transmission; and
an error recovery circuit (114) configured to cause the driver (110) to re-transmit the one or more transmitted compressed digital samples in response to an error in transmission of the compressed digital signal.

7. The system of any of the preceding claims, further comprising a multi-bit quantizer (120) configured to limit possible transitions between quantization levels of the uncompressed digital signal of consecutive samples of the uncompressed digital signal to a subset of the quantization levels of the uncompressed digital signal.

8. The system of claim 1 or 2, wherein the system is an integrated circuit and further comprises
a digital processing circuit (108) for processing at least one of the uncompressed digital signal and the compressed digital signal.

9. The system of claim 8, wherein the system further comprises
a second digital compression circuit (106B) configured to receive a second uncompressed digital signal having Y bits and compress the second uncompressed digital signal into a second compressed digital signal having Z bits, wherein Y and Z are each positive integers and Y>Z, and
a summing element (107) for summing the compressed digital signal and the second compressed digital signal,
wherein preferably, M=Y and/or N=Z.

10. The system of claim 8 or 9, wherein the digital processing circuit (108) processes at least one of the uncompressed digital signal and the compressed digital signal to perform voice detection.

11. A method comprising:
compressing an uncompressed digital signal into a compressed digital signal having fewer quantization levels than that of the uncompressed digital signal; and
for each given sample of the uncompressed digital signal, generating a corresponding sample of the compressed digital signal based on at least a first quantization level transition between the given sample and a first previous sample sampled consecutively previous to the given sample;
**characterised in that** the compressed digital signal is further based on
a second quantization level transition between the first previous sample and a second previous sample sampled consecutively previous to the first previous sample.

12. The method of claim 11, wherein:
the uncompressed digital signal comprises M bits;
the compressed digital signal comprises N bits; and
M and N are each positive integers and M>N.

13. The method of claim 11 or 12, further comprising, for each given sample of the uncompressed digital signal, generating a corresponding sample of the compressed digital signal based on transition statistics of a multi-bit quantizer (120).

14. The method of any of claims 11-13, wherein a function for compressing the uncompressed digital signal into the compressed digital signal is selected based on transition statistics of a multi-bit quantizer (120) in order to minimize transition frequency of bits making up the compressed digital signal, and/or
wherein a function for compressing the uncompressed digital signal into the compressed digital signal limits possible transitions between quantization levels of the uncompressed digital signal of consecutive samples of the uncompressed digital signal to a subset of the quantization levels of the uncompressed digital signal,
wherein preferably, the function limits possible transitions between quantization levels of the uncompressed digital signal of consecutive samples of the uncompressed digital signal in order to minimize degradation to the compressed digital signal.

15. The method of any of claims 11-14, further comprising:
transmitting the compressed digital signal;
storing one or more transmitted compressed digital samples of the compressed digital signal in order of transmission; and
re-transmitting the one or more transmitted compressed digital samples in response to an error in transmission of the compressed digital signal.

16. The method of claim 15, further comprising processing at least one of the uncompressed digital signal and the compressed digital signal to perform voice detection, to detect the presence of ultrasonic energy in an input signal, or to determine mel-frequency cepstral coefficients of the input signal.

17. The method of claim 15 or 16, further comprising determining a number of bits comprising the compressed digital signal based on the characteristic of an input signal.

18. The method of any of claims 15-17, further comprising setting the number of bits to a first number if an input signal has energy above a particular frequency and setting the number of bits to a second number if the input signal lacks energy above the particular frequency.

## Patentansprüche

1. System, umfassend:
eine digitale Kompressionsschaltung (106, 106A), die konfiguriert ist, um ein unkomprimiertes digitales Signal zu empfangen und das unkomprimierte digitale Signal in ein komprimiertes digitales Signal mit weniger Quantisierungsstufen als das unkomprimierte digitale Signal zu komprimieren, wobei die digitale Kompressionsschaltung für jeden gegebenen Abtastwert des unkomprimierten digitalen Signals einen entsprechenden Abtastwert des komprimierten digitalen Signals auf der Grundlage mindestens eines ersten Quantisierungsstufenübergangs zwischen dem gegebenen Abtastwert und einem ersten vorhergehenden Abtastwert erzeugt, der unmittelbar vor dem gegebenen Abtastwert abgetastet wurde;
**dadurch gekennzeichnet, dass** das komprimierte digitale Signal ferner auf einem zweiten Quantisierungsstufenübergang zwischen dem ersten vorhergehenden Abtastwert und einem zweiten vorhergehenden Abtastwert, der unmittelbar vor dem ersten vorhergehenden Abtastwert abgetastet wurde, basiert.

2. Das System nach Anspruch 1, wobei:
das unkomprimierte digitale Signal M Bits umfasst;
das komprimierte digitale Signal N Bits umfasst; und
M und N jeweils positive ganze Zahlen sind und M > N ist.

3. Das System nach Anspruch 1 oder 2, wobei die digitale Kompressionsschaltung (106, 106A) für jeden gegebenen Abtastwert des unkomprimierten digitalen Signals einen entsprechenden Abtastwert des komprimierten digitalen Signals auf der Grundlage der Übergangsstatistik eines Mehrbit-Quantisierers (120) erzeugt.

4. Das System nach einem der vorhergehenden Ansprüche, wobei eine Funktion der digitalen Kompressionsschaltung (106, 106A) zum Komprimieren des unkomprimierten digitalen Signals in das komprimierte digitale Signal auf der Grundlage der Übergangsstatistik eines Mehrbit-Quantisierers (120) ausgewählt wird, um die Übergangsfrequenz der Bits, aus denen das komprimierte digitale Signal besteht, zu minimieren, und/oder
wobei eine Funktion der digitalen Kompressionsschaltung (106, 106A) zum Komprimieren des unkomprimierten digitalen Signals in das komprimierte digitale Signal mögliche Übergänge zwischen Quantisierungsstufen des unkomprimierten digitalen Signals aufeinanderfolgender Abtastwerte des unkomprimierten digitalen Signals auf eine Teilmenge der Quantisierungsstufen des unkomprimierten digitalen Signals beschränkt,
wobei vorzugsweise die Funktion mögliche Übergänge zwischen Quantisierungsstufen des unkomprimierten digitalen Signals bei aufeinanderfolgenden Abtastwerten des unkomprimierten digitalen Signals begrenzt, um eine Verschlechterung des komprimierten digitalen Signals zu minimieren.

5. Das System nach einem der vorhergehenden Ansprüche, ferner umfassend eine Verarbeitungsschaltung (116) zum Dekomprimieren des komprimierten digitalen Signals.

6. Das System nach einem der vorhergehenden Ansprüche, ferner umfassend:
einen Treiber (110), der konfiguriert ist, um das komprimierte digitale Signal zu übertragen;
einen Speicher (112), der konfiguriert ist, um eine oder mehrere gesendete komprimierte digitale Abtastwerte des komprimierten digitalen Signals in der Reihenfolge ihrer Übertragung zu speichern; und
eine Fehlerbehebungsschaltung (114), die konfiguriert ist, um den Treiber (110) dazu zu veranlassen, die eine oder mehreren gesendeten komprimierten digitalen Abtastwerte als Reaktion auf einen Fehler bei der Übertragung des komprimierten digitalen Signals erneut zu senden.

7. Das System nach einem der vorhergehenden Ansprüche, ferner umfassend einen Mehrbit-Quantisierer (120), der konfiguriert ist, um mögliche Übergänge zwischen Quantisierungsstufen des unkomprimierten digitalen Signals von aufeinanderfolgenden Abtastwerten des unkomprimierten digitalen Signals auf eine Teilmenge der Quantisierungsstufen des unkomprimierten digitalen Signals zu beschränken.

8. Das System nach Anspruch 1 oder 2, wobei das System eine integrierte Schaltung ist und ferner umfasst
eine digitale Verarbeitungsschaltung (108) zum Verarbeiten zumindest eines von dem unkomprimierten digitalen Signal und dem komprimierten digitalen Signal.

9. Das System nach Anspruch 8, wobei das System ferner umfasst
eine zweite digitale Kompressionsschaltung (106B), die konfiguriert ist, um ein zweites unkomprimiertes digitales Signal mit Y Bits zu empfangen und das zweite unkomprimierte digitale Signal zu einem zweiten komprimierten digitalen Signal mit Z Bits zu komprimieren, wobei Y und Z jeweils positive ganze Zahlen sind und Y > Z ist, und
ein Summierelement (107) zum Summieren des komprimierten digitalen Signals und des zweiten komprimierten digitalen Signals,
wobei vorzugsweise M = Y und/oder N = Z ist.

10. Das System nach Anspruch 8 oder 9, wobei die digitale Verarbeitungsschaltung (108) mindestens eines der unkomprimierten digitalen Signale und der komprimierten digitalen Signale verarbeitet, um eine Spracherkennung durchzuführen.

11. Ein Verfahren, das Folgendes umfasst:
Komprimieren eines unkomprimierten digitalen Signals zu einem komprimierten digitalen Signal mit weniger Quantisierungsstufen als das unkomprimierte digitale Signal; und
für jeden gegebenen Abtastwert des unkomprimierten digitalen Signals Erzeugen eines entsprechenden Abtastwerts des komprimierten digitalen Signals auf der Grundlage mindestens eines ersten Quantisierungsstufenübergangs zwischen dem gegebenen Abtastwert und einem ersten vorhergehenden Abtastwert, der unmittelbar vor dem gegebenen Abtastwert abgetastet wurde;
**dadurch gekennzeichnet, dass** das komprimierte digitale Signal ferner auf einem zweiten Quantisierungsstufenübergang zwischen der ersten vorhergehenden Abtastwert und einem zweiten vorhergehenden Abtastwert, der unmittelbar vor dem ersten vorhergehenden Abtastwert abgetastet wurde, basiert.

12. Das Verfahren nach Anspruch 11, wobei:
das unkomprimierte digitale Signal M Bits umfasst;
das komprimierte digitale Signal N Bits umfasst; und
M und N jeweils positive ganze Zahlen sind und M > N ist.

13. Das Verfahren nach Anspruch 11 oder 12, ferner umfassend Erzeugen eines entsprechenden Abtastwerts des komprimierten digitalen Signals für jeden gegebenen Abtastwert des unkomprimierten digitalen Signals auf der Grundlage der Übergangsstatistik eines Mehrbit-Quantisierers (120).

14. Das Verfahren nach einem der Ansprüche 11-13, wobei eine Funktion zum Komprimieren des unkomprimierten digitalen Signals in das komprimierte digitale Signal auf der Grundlage der Übergangsstatistik eines Mehrbit-Quantisierers (120) ausgewählt wird, um die Übergangsfrequenz der Bits, aus denen das komprimierte digitale Signal besteht, zu minimieren, und/oder
wobei eine Funktion zum Komprimieren des unkomprimierten digitalen Signals in das komprimierte digitale Signal mögliche Übergänge zwischen Quantisierungsstufen des unkomprimierten digitalen Signals aufeinanderfolgender Abtastwerte des unkomprimierten digitalen Signals auf eine Teilmenge der Quantisierungsstufen des unkomprimierten digitalen Signals beschränkt,
wobei die Funktion vorzugsweise mögliche Übergänge zwischen Quantisierungsstufen des unkomprimierten digitalen Signals aufeinanderfolgender Abtastwerte des unkomprimierten digitalen Signals beschränkt, um eine Verschlechterung des komprimierten digitalen Signals zu minimieren.

15. Das Verfahren nach einem der Ansprüche 11 bis 14, ferner umfassend:
Senden des komprimierten digitalen Signals;
Speichern einer oder mehrerer gesendeter komprimierter digitaler Abtastwerte des komprimierten digitalen Signals in der Reihenfolge ihrer Übertragung; und
erneutes Senden der einen oder mehreren gesendeten komprimierten digitalen Abtastwerte als Reaktion auf einen Fehler bei der Übertragung des komprimierten digitalen Signals.

16. Das Verfahren nach Anspruch 15, ferner umfassend Verarbeiten zumindest eines von dem unkomprimierten digitalen Signal und dem komprimierten digitalen Signal, um eine Spracherkennung durchzuführen, um das Vorhandensein von Ultraschallenergie in einem Eingangssignal zu erkennen oder um Mel-Frequenz-Cepstrum-Koeffizienten des Eingangssignals zu bestimmen.

17. Das Verfahren nach Anspruch 15 oder 16, ferner umfassend Bestimmen einer Anzahl von Bits, aus denen das komprimierte digitale Signal besteht, auf der Grundlage der Eigenschaften eines Eingangssignals.

18. Das Verfahren nach einem der Ansprüche 15-17, ferner umfassend Einstellen der Anzahl von Bits auf eine erste Zahl, wenn ein Eingangssignal Energie oberhalb einer bestimmten Frequenz aufweist, und das Einstellen der Anzahl von Bits auf eine zweite Zahl, wenn dem Eingangssignal Energie oberhalb der bestimmten Frequenz fehlt.

## Revendications

1. Système comprenant :
un circuit de compression numérique (106, 106A) configuré pour recevoir un signal numérique non compressé et pour compresser le signal numérique non compressé en un signal numérique compressé possédant moins de niveaux de quantification que le signal numérique non compressé,
dans lequel, pour chaque échantillon donné du signal numérique non compressé, le circuit de compression numérique génère un échantillon correspondant du signal numérique compressé sur la base d'au moins une première transition de niveau de quantification entre l'échantillon donné et un premier échantillon antérieur échantillonné consécutivement antérieurement à l'échantillon donné ; **caractérisé en ce que** le signal numérique compressé est en outre basé sur une seconde transition de niveau de quantification entre le premier échantillon antérieur et un second échantillon antérieur échantillonné consécutivement antérieurement au premier échantillon antérieur.

2. Système selon la revendication 1, dans lequel :
le signal numérique non compressé comprend M bits ;
le signal numérique compressé comprend N bits ; et
M et N sont tous les deux des entiers positifs et M > N.

3. Système selon la revendication 1 ou 2, dans lequel, pour chaque échantillon donné du signal numérique non compressé, le circuit de compression numérique (106, 106A) génère un échantillon correspondant du signal numérique compressé sur la base de statistiques de transition d'un quantificateur à bits multiples (120).

4. Système selon l'une quelconque des revendications précédentes, dans lequel une fonction du circuit de compression numérique (106, 106A) pour compresser le signal numérique non compressé en un signal numérique compressé est sélectionnée sur la base de statistiques de transition d'un quantificateur à bits multiples (120) afin de minimiser une fréquence de transition de bits constituant le signal numérique compressé, et/ou
dans lequel une fonction du circuit de compression numérique (106, 106A) pour compresser le signal numérique non compressé en un signal numérique compressé limite des transitions possibles entre des niveaux de quantification du signal numérique non compressé d'échantillons consécutifs du signal numérique non compressé à un sous-ensemble des niveaux de quantification du signal numérique non compressé, et
dans lequel de préférence, la fonction limite des transitions possibles entre des niveaux de quantification du signal numérique non compressé d'échantillons consécutifs du signal numérique non compressé afin de minimiser une dégradation du signal numérique compressé.

5. Système selon l'une quelconque des revendications précédentes, comprenant en outre un circuit de traitement (116) pour décompresser le signal numérique compressé.

6. Système selon l'une quelconque des revendications précédentes, comprenant en outre :
un pilote (110) configuré pour transmettre le signal numérique compressé ;
une mémoire (112) configurée pour stocker un ou plusieurs échantillons numériques compressés transmis du signal numérique compressé dans l'ordre de transmission ; et
un circuit de récupération d'erreur (114) configuré pour forcer le pilote (110) à retransmettre les un ou plusieurs échantillons numériques compressés transmis en réponse à une erreur dans la transmission du signal numérique compressé.

7. Système selon l'une quelconque des revendications précédentes, comprenant en outre un quantificateur à bits multiples (120) configuré pour limiter des transitions possibles entre des niveaux de quantification du signal numérique non compressé d'échantillons consécutifs du signal numérique non compressé à un sous-ensemble des niveaux de quantification du signal numérique non compressé.

8. Système selon la revendication 1 ou 2, dans lequel le système est un circuit intégré et comprend en outre :
un circuit de traitement numérique (108) pour traiter au moins un signal parmi le signal numérique non compressé et le signal numérique compressé.

9. Système selon la revendication 8, dans lequel le système comprend en outre :
un second circuit de compression numérique (106B) configuré pour recevoir un second signal numérique non compressé possédant Y bits et pour compresser le second signal numérique non compressé en un second signal numérique compressé possédant Z bits, dans lequel Y et Z sont tous les deux des entiers positifs et Y > Z ; et
un élément sommateur (107) pour sommer le signal numérique compressé et le second signal numérique compressé,
dans lequel, de préférence M=Y et/ou N=Z.

10. Système selon la revendication 8 ou 9, dans lequel le circuit de traitement numérique (108) traite au moins un signal parmi le signal numérique non compressé et le signal numérique compressé pour effectuer une détection vocale.

11. Procédé comprenant :
la compression d'un signal numérique non compressé en un signal numérique compressé possédant moins de niveaux de quantification que le signal numérique non compressé ; et
pour chaque échantillon donné du signal numérique non compressé, la génération d'un échantillon correspondant du signal numérique compressé sur la base d'au moins une première transition de niveau de quantification entre l'échantillon donné et un premier échantillon antérieur échantillonné consécutivement antérieurement à l'échantillon donné ;
**caractérisé en ce que** le signal numérique compressé est en outre basé sur une seconde transition de niveau de quantification entre le premier échantillon antérieur et un second échantillon antérieur échantillonné consécutivement antérieurement au premier échantillon antérieur.

12. Procédé selon la revendication 11, dans lequel :
le signal numérique non compressé comprend M bits ;
le signal numérique compressé comprend N bits ; et
M et N sont tous les deux des entiers positifs et M > N.

13. Procédé selon la revendication 11 ou 12, comprenant en outre, pour chaque échantillon donné du signal numérique non compressé, la génération d'un échantillon correspondant du signal numérique compressé sur la base de statistiques de transition d'un quantificateur à bits multiples (120).

14. Procédé selon l'une quelconque des revendications 11 à 13, dans lequel une fonction pour compresser le signal numérique non compressé en un signal numérique compressé est sélectionnée sur la base de statistiques de transition d'un quantificateur à bits multiples (120) afin de minimiser une fréquence de transition de bits constituant le signal numérique compressé, et/ou
dans lequel une fonction pour compresser le signal numérique non compressé en un signal numérique compressé limite des transitions possibles entre des niveaux de quantification du signal numérique non compressé d'échantillons consécutifs du signal numérique non compressé à un sous-ensemble des niveaux de quantification du signal numérique non compressé, et
dans lequel de préférence, la fonction limite des transitions possibles entre des niveaux de quantification du signal numérique non compressé d'échantillons consécutifs du signal numérique non compressé afin de minimiser une dégradation du signal numérique compressé.

15. Procédé selon l'une quelconque des revendications 11 à 14, comprenant en outre :
la transmission du signal numérique compressé ;
le stockage d'un ou de plusieurs échantillons numériques compressés transmis du signal numérique compressé dans l'ordre de transmission ; et
la retransmission des un ou plusieurs échantillons numériques compressés transmis en réponse à une erreur dans la transmission du signal numérique compressé.

16. Procédé selon la revendication 15, comprenant en outre le traitement d'au moins un signal parmi le signal numérique non compressé et le signal numérique compressé pour effectuer une détection vocale, pour détecter la présence d'une énergie ultrasonore dans un signal d'entrée ou pour déterminer des coefficients cepstraux de fréquence mel du signal d'entrée.

17. Procédé selon la revendication 15 ou 16, comprenant en outre la détermination d'un nombre de bits constituant le signal numérique compressé sur la base de la caractéristique d'un signal d'entrée.

18. Procédé selon l'une quelconque des revendications 15 à 17, comprenant en outre la définition du nombre de bits à un premier nombre si un signal d'entrée possède une énergie supérieure à une fréquence particulière et la définition du nombre de bits à un second nombre si le signal d'entrée ne possède pas une énergie supérieure à la fréquence particulière.
